# EUROPEAN PATENT SPECIFICATION

(11) **EP 0 632 579 B1**
(45) Date of publication and mention of the grant of the patent: **24.02.1999**
(21) Application number: 94107895.8
(22) Date of filing: 21.05.1994
(51) Int. Cl.: H03F 1/30, H03K 5/00

(54) **DC control circuit in bursted data receivers**
Gleichstromsteuerungsschaltung in Burst-Datenempfängern
Circuit de commande de courant continu dans des récepteurs de données en rafales

(30) Priority: 31.05.1993 ES 9301186
(43) Date of publication of application: 04.01.1995
(73) Proprietor: ALCATEL N.V., NL-1077 XX Amsterdam (NL)
(72) Inventor: Eldering, Charles A., Willow Grove, PA 19090 (US); Martin Gomez, Raquel, E-28033 Madrid (ES)
(74) Representative: Feray, Valérie

(56) References cited:
- EP-A- 0 491 186
- GB-A- 2 162 010
- REVIEW OF SCIENTIFIC INSTRUMENTS, vol. 58, no. 6, June 1987 NEW YORK US, pages 1104-1105, M. GRUBIC 'GATED BASE-LINE RESTORER WITHOUT "DROOP"'

## Description

### OBJECT OF THE INVENTION

This invention concerns a circuit that restores the variations in DC level present in the signal received by a bursted data receiver, in such a way that the increases in this level resulting from the reception of the data bursts are eliminated.

It is of special application in bursted data optical receivers.

### BACKGROUND TO THE INVENTION

Optical receivers contain an opto-electrical transducer based generally on a PINFET and an amplifier that produces at its output an electrical signal with an amplitude proportional to the optical power received over an optical fibre.

These components generate at their output signals that have a DC component, in the absence of received optical power, that basically depends on the PINFET bias current and on the amplifier bias currents This DC component therefore, is subject to serious drifts that depend heavily on other uncontrollable factors such as temperature, ageing, etc.

This means that DC coupling between the opto-electical transducer and the following blocks is not possible unless these drift effects are allowed for. For this reason it is common practice to insert a direct current decoupling capacitor at the output of the transducer mentioned and thereby overcome this inconvenience.

The document GB-A-2 162 010 discloses an amplifier including such a capacitor.

Nevertheless, in systems like that described here, there is the additional drawback that the received bursts have a major low frequency component, meaning that the time constant of the circuit formed by this capacitor and the equivalent input resistance of the amplifier must be high in order to permit the lowest frequencies in the signal to pass. This situation means that the direct current decoupling capacitor alters its charge at the end of each burst by an amount that depends on the amplitude of the high logic level ( hereafter "1"), on the number of bursts, and on the ratio between the number of bits with value "1" and with value "0" in each burst.

As a result of the foregoing it can happen that the value of the capacitor charge, after a few frames, is sufficiently large to prevent the detector circuit from correctly recovering the burst as the "0" logic level has shifted for the burst in question by an unknown amount; this could lead to the setting of an erroneous detection threshold or, at least, one that is not optimum.

### TECHNICAL PROBLEM TO BE OVERCOME

As a result the technical problem to be overcome consists in compensating the variations in the DC component that appear on the direct current decoupling capacitor in data burst transmission systems.

### CHARACTERISATION OF THE INVENTION

This invention which makes use of a line receiver to perform the conversion of data signals of any type received over a determined communication medium to signals of an electrical type, of a direct current decoupling circuit to isolate the DC component from the line receiver and of a first amplifier to boost the electrical signal level present after the decoupling circuit, is characterised in that it comprises a control circuit that measures the DC component present at the input of the first amplifier in a cyclic manner, during the frame instants when no signal is being received. The invention is also characterised in that it also comprises a current generator, which supplies the input node of the first amplifier with a current the value of which is determined by the control circuit in such a way the charge on the capacitor of the direct current decoupling circuit is altered in the sense of compensating the increase of the DC component on the extremities of this capacitor as a consequence of data burst reception.

In this way the DC component of the input signal to the first amplifier, generated as a result of charge building up on the capacitor and due to the form of the received data, is compensated by the current delivered by the current generator so that in the event of receiving bursts with a determined minimum amplitude, the "0" logic level of this burst is close to zero volts.

### BRIEF FOOTNOTES TO THE FIGURES

A more detailed explanation of the invention is made based on the following figures, in which:

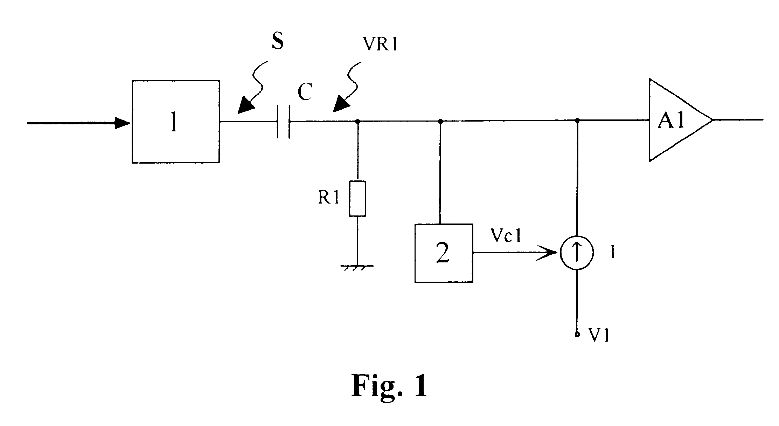

- figure 1 shows a general circuit for performing the DC control in accordance with the invention,

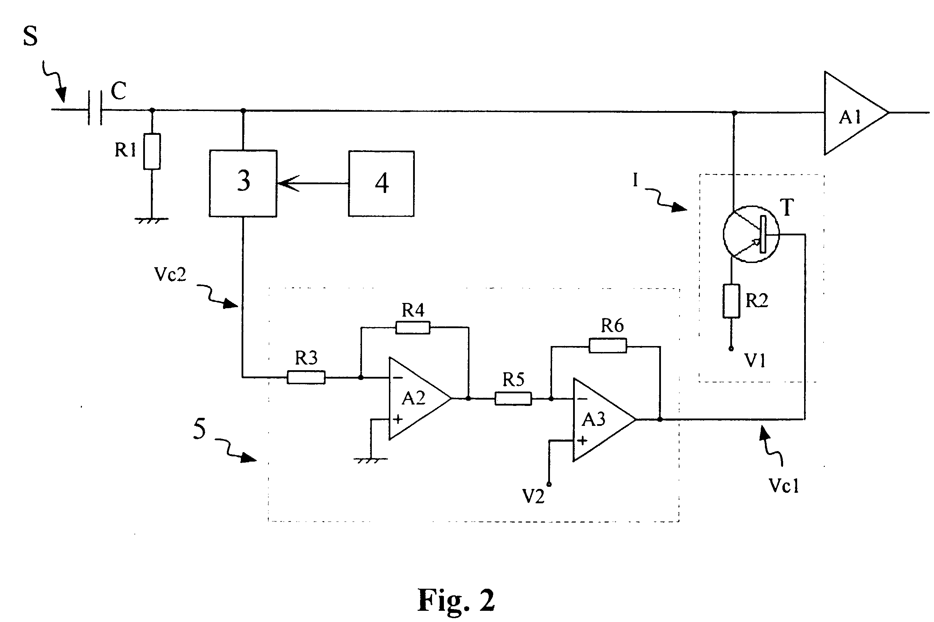

- figure 2 shows an implementation of the DC control circuit according to the invention, and
- figure 3 shows the evolution with time of the signals present at various points of the circuit over the period of several frames.

### DESCRIPTION OF THE INVENTION

This invention, in a recommended implementation, has been conceived for an optical fibre transmission system consisting of a line receiver 1, comprising, in turn, a PINFET diode and an amplifier (not shown), that performs the conversion of the data signals received over an optical fibre into electrical signals S. The output of this line receiver 1 is connected to a direct current decoupling circuit, formed, in turn, by a capacitor C and a resistor R1, such that the DC component at the output of the line receiver 1 (the value of which varies widely depending on parameters such as temperature, ageing, etc.) is perfectly decoupled.

Due to the high bit rate employed in optical fibre transmission, it could be imagined that the time constant need not necessarily be high.

However, for various reasons, it is necessary that this time constant be high with respect to the bit period. Thus, for example, in this case, with values of C=47 µF and R=600 Ω, the time constant is 28 ms, which is very large compared to the bit period which is about 20 ns.

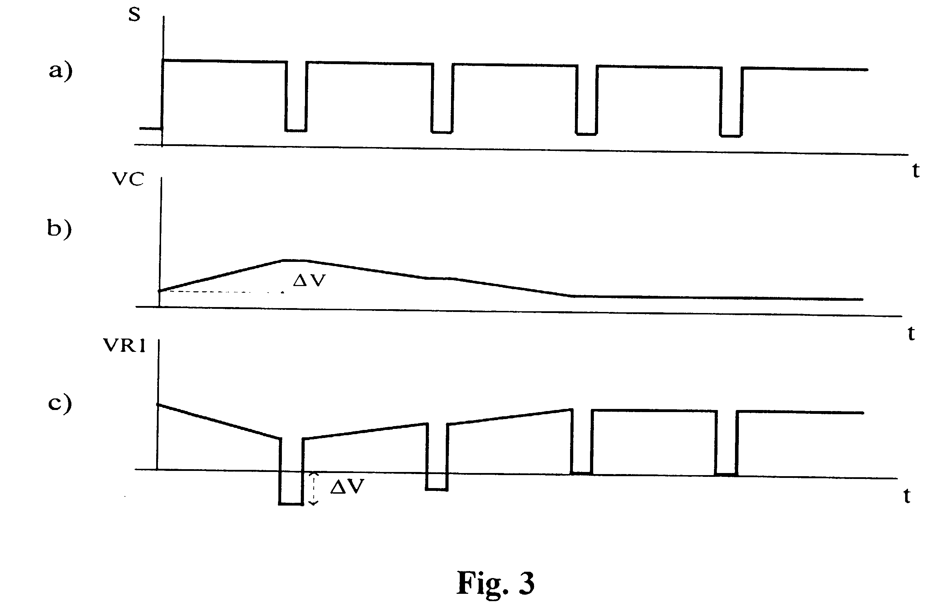

Figure 3-a) shows the signal S present at the output of the line receiver 1 where the received data correspond to a series of complete frames of consecutive ones, the length of each frame being approximately 500 µs. Figure 3-b) shows the development of the voltage across the capacitor C of the direct current decoupling circuit C,R1.

Figure 3-c) shows the development of the signal at the output of the direct current decoupling circuit C,R1, in which it can be seen how the increase in capacitor charge produced by the first burst is gradually compensated in tile following bursts until the same voltage is obtained on both capacitor terminals.

This increase is measured by the control circuit 2 which generates a first control voltage Vc1 that is applied to a current generator I which, in turn, provides a suitable current to compensate the preceding increase in voltage. This control circuit consists of a sample and hold means 3 that samples the signal at its input in a periodic manner according to a frame clock 4 at the frame instants when no signal is being received. The output signal from this sample and hold means 3 is a second control signal Vc2 that is applied to a direct current adapting circuit 5 which converts this second control signal Vc2 into the first control signal Vc1 the value of which is suitable to make the current generated by the current generator I compensate the initial voltage increase.

To achieve this, the direct current adapting circuit 5 is made up of a first inverter amplifier R3,R4,A2 that amplifies and inverts the second control signal Vc2 and a second inverter amplifier R5,R6,A3 that amplifies and inverts the difference between the signal coming from the first inverter amplifier R3,R4,A2 and a second reference voltage V2, producing in this way the first control signal Vc1.

The current generator I has been designed with a PNP bipolar transistor T, the base of which receives the first control signal Vc1 and whose emitter is connected to another reference voltage V1 through a resistor R2, whereby the collector output current tends to bring the input voltage of the amplifier A1 to a value close to zero volts (reference value when no received signal), using for this the necessary number of frames.

## Claims

1. BURSTED DATA RECEIVER WITH DC CONTROL which comprises a line receiver (1) for performing the conversion of data signals received over a communication medium into signals of an electrical nature (S), a direct current decoupling circuit (C,R1) and a first amplifier (A1) to boost the level of the received electrical signal, **characterised** in that it also comprises:
- a control circuit (2) for performing the measurement of the DC component present at the input of the first amplifier (A1) in a cyclic manner during the frame instants when no signal is being received, and
- a current generator (I) that supplies the input node of the first amplifier (A1) with a current whose value is determined by the control circuit (2), in such a way that the charge on the capacitor (C) is altered in the sense of compensating the increase in the DC component across this capacitor (C) produced as a result of the number of data bursts received, of the amplitude of the bit with value "1" and of the ratio between the number of bits of value "1" and of value "0" in each burst.

2. RECEIVER according to claim 1, **characterised** in that the current generator (I) comprises a bipolar PNP transistor (T) to the base of which is applied a first control signal (Vc1) coming from the control circuit (2), whose emitter is connected to one extremity of a second resistor (R2) and whose collector is connected to the input node of the first amplifier (A1) such that it supplies a direct compensating current, the other extremity of the second resistor (R2) being connected to a first reference voltage (V1).

3. **RECEIVER** according to claim 1, **characterised** in that the control circuit (2) comprises sample and hold means (3) of its input signal, these sample and hold means receiving a clock signal coming from a clock circuit (4) in order to perform the sampling process during the frame instants when no signal is being received and the holding process during the rest of the time, and to generate at its output a second control signal (Vc2) that is applied to a direct current adapting circuit (5) which, in turn, generates the first control signal (Vc1), whereby the current supplied by the current generator (I) tends to compensate the DC component measured at the input of the sample and hold means (3).

4. **RECEIVER** according to claim 3, **characterised** in that the direct current adapting circuit (5) comprises a first inverter amplifier (R3,R4,A2) that amplifies and inverts the second control signal (Vc2) coming from the sample and hold means (3), and a second inverter amplifier (R5,R6,A3) that amplifies and inverts the difference between the signal coming from the first inverter amplifier (R3,R4,A2) and a second reference voltage (V2), in order to generate in this way the first control signal (Vc1).

## Patentansprüche

1. Datenpaketempfänger mit Gleichstromsteuerung mit einem Leitungsempfänger (1) zur Ausführung der Umwandlung von Datensignalen, die über ein Kommunikationsmittel empfangen worden sind, in Signale von elektrischer Natur (S), einer Gleichstromentkopplungsschaltung (C, R1) und einem ersten Verstärker (A1) zur Verstärkung des Pegels des empfangenen elektrischen Signals, dadurch gekennzeichnet, daß sie auch aufweist:
- eine Steuerschaltung (2) zur Ausführung der Messung des Gleichstrombestandteils, der am Eingang des ersten Verstärkers (Al) anliegt in einer zyklischen Weise, während Frame-Zeitpunkten, bei denen kein Signal empfangen wird, und
- eine Stromquelle (I), der den Eingangsanschluß des ersten Verstärkers (Al) mit einem Strom versorgt, dessen Wert bestimmt wird von der Steuerschaltung (2) auf solche Weise, daß die Ladung an einem Kondensator (C) verändert wird im Sinne eines Ausgleichs des Anstiegs in der Gleichstromkomponente über diesem Kondensator (C), die erzeugt wird als eine Folge der Zahl der empfangenen Datenpaketen, der Amplitude der Bits mit dem Wert "1" und dem Verhältnis der Zahl der Bits mit dem Wert "1" und dem Wert "0" in jedem Paket.

2. Empfänger nach Anspruch 1, dadurch gekennzeichnet, daß die Stromquelle (I) einen bipolaren PNP Transistor (T) aufweist, an dessen Basis ein erstes Steuersignal (Vcl) anliegt, welches von der Steuerschaltung (2) kommt, und dessen Emitter mit einem Ausgang eines zweiten Widerstands (R2) verbunden ist und dessen Kollektor mit dem Eingangsanschluß des ersten Verstärkers (Al) verbunden ist, derart, daß er einen Ausgleichsstrom zur Verfügung stellt, wobei der andere Anschluß des zweiten Widerstands (R2) mit einer ersten Referenzspannung (V1) verbunden ist.

3. Empfänger nach Anspruch 1, dadurch gekennzeichnet, daß die Steuerschaltung (2) ein Abtast- und Halteeinrichtung (3) ihres Eingangssignals aufweist, wobei diese Abtast- und Halteeinrichtung ein Taktsignal empfängt, welches von einer Taktschaltung (4) kommt und zwar zur Ausführung des Abtastvorgangs während Frame-Zeitpunkten, wenn kein Signal empfangen wird und des Haltevorgangs während der Rest der Zeit und zur Erzeugung eines zweiten Steuersignals (Vc2) an ihrem Ausgang, welches an einer Gleichstromeinstellschaltung (5) angelegt wird, die ihrerseits das erste Steuersignal (Vcl) erzeugt, wodurch der von der Stromquelle bereit gestellte Strom zum Ausgleich der Gleichstromkomponente führt, die am Eingang der Abtast- und Halteeinrichtung (3) gemessen wird.

4. Empfänger nach Anspruch 3, dadurch gekennzeichnet, daß die Gleichstromeinstellschaltung (5) einen ersten Umkehrverstärker (R3, R4, A2) aufweist, der das zweite Steuersignal (Vc2) verstärkt und invertiert, welches von der Abtast- und Halteeinrichtung (3) kommt, und einen zweiten Umkehrverstärker (R5, R6, A3), der die Differenz zwischen dem Signal, welches von dem ersten Umkehrverstärker (R3, R4, A2) und einer zweiten Referenzspannung (V2) kommt, verstärkt und invertiert und zwar zur Erzeugung des ersten Steuersignals (Vcl) auf diese Weise.

## Revendications

1. Récepteur de données par salves avec contrôle de courant continu, qui comprend un récepteur de ligne (1) pour effectuer la conversion des signaux de données reçus sur un support de communication en signaux d'une nature électrique (S), un circuit de découplage de courant continu (C, R1) et un premier amplificateur (A1) pour amplifier le niveau du signal électrique reçu, caractérisé en ce qu'il comprend également :
- un circuit de contrôle (2) pour effectuer la mesure de la composante continue présente à l'entrée du premier amplificateur (A1) d'une manière cyclique pendant les instants de trame auxquels aucun signal n'est reçu, et
- un générateur de courant (I) qui délivre, au noeud d'entrée du premier amplificateur (A1), un courant dont la valeur est déterminée par le circuit de contrôle (2), d'une manière telle que la charge sur le condensateur (C) soit modifiée dans le sens de la compensation de l'augmentation de la composante continue aux bornes de ce condensateur (C) produite en conséquence du nombre de salves de données reçues, de l'amplitude du bit de valeur "1" et du rapport entre le nombre de bits de valeur "1" et de valeur "0" dans chaque salve.

2. Récepteur selon la revendication 1, caractérisé en ce que le générateur de courant (I) comprend un transistor bipolaire PNP (T), à la base duquel est appliqué un premier signal de commande (Vc1) provenant du circuit de contrôle (2), dont l'émetteur est connecté à une extrémité d'une seconde résistance (R2), et dont le collecteur est connecté au noeud d'entrée du premier amplificateur (A1), de sorte qu'il délivre un courant continu de compensation, l'autre extrémité de la seconde résistance (R2) étant connectée à la première tension de référence (V1).

3. Récepteur selon la revendication 1, caractérisé en ce que le circuit de contrôle (2) comprend des moyens d'échantillonnage et de maintien (3) de son signal d'entrée, ces moyens d'échantillonnage et de maintien recevant un signal d'horloge provenant d'un circuit d'horloge (4) pour exécuter l'opération d'échantillonnage pendant les instants de trame auxquels aucun signal n'est reçu et l'opération de maintient pendant le reste du temps, et pour générer, à sa sortie, un second signal de commande (Vc2) qui est appliqué à un circuit d'adaptation de courant continu (5) qui, à son tour, génère le premier signal de commande (Vc1), de telle manière que le courant délivré par le générateur de courant (I) tende à compenser la composante continue mesurée à l'entrée des moyens d'échantillonnage et de maintien (3).

4. Récepteur selon la revendication 3, caractérisé en ce que le circuit d'adaptation de courant continu (5) comprend un premier amplificateur inverseur (R3, R4, A2) qui amplifie et inverse le second signal de commande (Vc2) provenant des moyens d'échantillonnage et de maintien (3) et un second amplificateur inverseur (R5, R6, A3) qui amplifie et inverse la différence entre le signal provenant du premier amplificateur inverseur (R3, R4, A2) et une seconde tension de référence (V2), afin de générer de cette manière le premier signal de commande (Vc1).
